(19) Europäisches Patentamt
European Patent Office
Office européen des brevets

(11) Numéro de publication : **0 181 807**
**B1**

(12) **FASCICULE DE BREVET EUROPÉEN**

(45) Date de publication du fascicule du brevet :
26.04.89

(21) Numéro de dépôt : **85402073.2**

(22) Date de dépôt : **25.10.85**

(51) Int. Cl.⁴ : **H 03 F   1/26,** H 03 F   3/195

(54) **Dispositif pour l'amplification sélective de signaux radio-électriques.**

(30) Priorité : **30.10.84 FR 8416597**

(43) Date de publication de la demande :
**21.05.86 Bulletin 86/21**

(45) Mention de la délivrance du brevet :
**26.04.89 Bulletin 89/17**

(84) Etats contractants désignés :
**DE GB IT**

(56) Documents cités :
**DE–A– 1 616 342**
**FR–A– 1 479 458**
**RADIO MENTOR, vol. 29, no. 9, septembre 1963,
pages 753-757, Munich, DE; H. WOLGEMUTH et al.:
"Ein Antennenverstärker mit Transistoren und flachen Leitungskreisen für den Fernsehbereich IV/V"**

(73) Titulaire : **THOMSON-CSF**
**173, Boulevard Haussmann**
**F-75379 Paris Cédex 08 (FR)**

(72) Inventeur : **Trumpff, Jean-Michel**
**THOMSON-CSF SCPI-173, bld Haussmann**
**F-75379 Paris Cedex 08 (FR)**

(74) Mandataire : **Lincot, Georges et al**
**THOMSON-CSF SCPI**
**F-92045 PARIS LA DEFENSE CEDEX 67 (FR)**

**Description**

La présente invention concerne un dispositif pour l'amplification sélective de signaux radioélectriques.

Elle s'applique à la réalisation de filtres passe-bandes pour signaux à niveau d'énergie élevé, très sélectifs, à rapport signal à bruit hors bande très élevé et à très forte réjection des raies parasites en dehors de la bande passante.

Une méthode, habituellement utilisée pour réaliser des filtres ayant les caractéristiques précitées, consiste à effectuer un filtrage sommaire du signal, avant de l'amplifier pour l'appliquer à l'entrée d'un filtre nettement plus élaboré pour satisfaire les conditions de filtrage exigées. Toutefois, lorsque l'énergie du signal filtré est importante, cette méthode ne rend pas entière satisfaction car il est difficile d'obtenir, dans l'état actuel de la technologie, des filtres très sélectifs à rapport signal à bruit hors bande élevé et dépourvus de résonances parasites en dehors de la bande de filtrage réalisée.

Le but de l'invention est de pallier les inconvénients précités.

A cet effet, l'invention a pour objet, un dispositif pour l'amplification sélective de signaux radioélectriques comprenant un premier amplificateur sur l'entrée duquel est appliqué le signal à amplifier, un deuxième amplificateur couplé à la sortie du premier amplificateur à travers un premier filtre passe bande, ainsi qu'un deuxième filtre passe bande couplé à la sortie du deuxième amplificateur fournissant le signal résultant filtré caractérisé en ce que le premier amplificateur a une caractéristique d'amplification déterminée pour que le rapport des énergies du signal obtenu à la sortie du premier filtre et du bruit thermique existant à la sortie du premier filtre soit à peu près égal au rapport des énergies signal à bruit thermique recherché à la sortie du deuxième filtre, les premier et deuxième filtres ayant des bandes passantes identiques, le deuxième filtre ayant une valeur d'atténuation hors bande à peu près égale à la valeur du facteur de bruit du deuxième amplificateur.

L'invention a pour avantage qu'elle offre un moyen efficace à la fois simple et économique pour optimiser les chaînes de filtrage de signaux radioélectriques lorsque ce filtrage s'effectue à un niveau d'énergie très élevé du signal. Cette simplicité de réalisation permet de l'appliquer à tous systèmes d'émission et aux générateurs de signaux nécessitant un filtrage passe-bande à fort niveau avec un niveau de bruit et de parasite hors bande très faible. En particulier, l'invention peut s'appliquer de façon efficace à la réalisation des chaînes de filtrage à fréquence intermédiaire des émetteurs de radiocommunication.

D'autres caractéristiques et avantages de l'invention apparaîtront également à l'aide de la description qui va suivre faite au regard des dessins annexés qui représentent :

la figure 1 un dispositif de filtrage sélectif de signaux radioélectriques selon l'invention ;

les figures 2 à 4 des spectres de signaux obtenus aux différents points de la chaîne de filtrage du dispositif selon l'invention représentés à la figure 1.

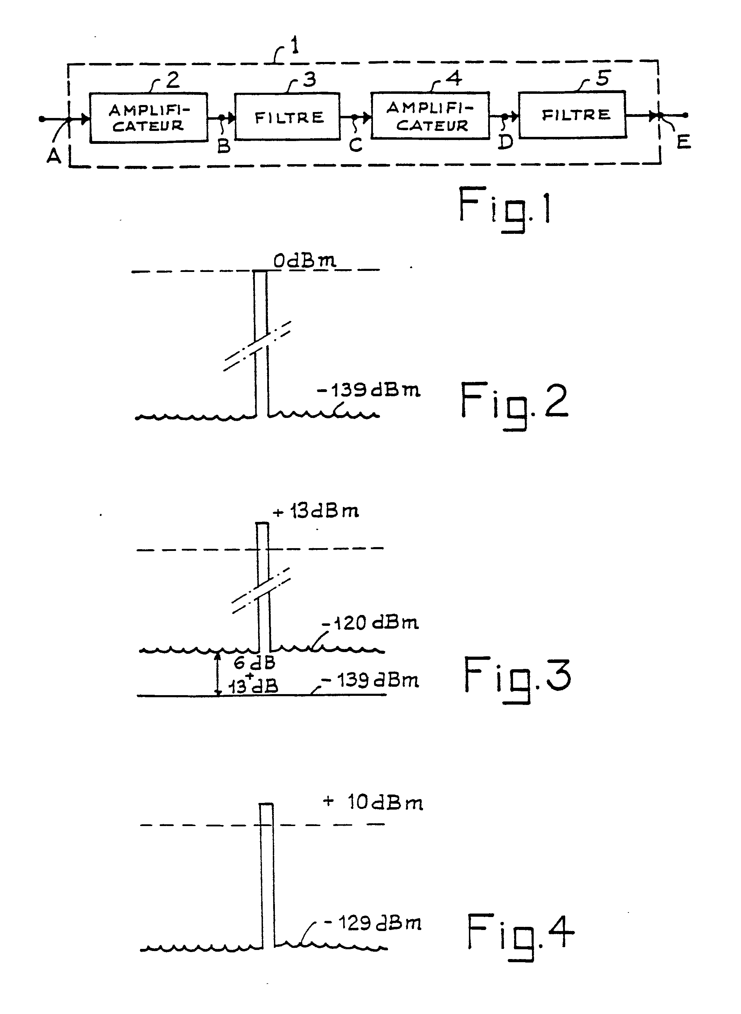

Le dispositif de filtrage selon l'invention qui est représenté en 1 à la figure 1 à l'intérieur d'un rectangle en pointillés comprend un premier amplificateur 2, un premier filtre passe-bande 3, un deuxième amplificateur 4, et un deuxième filtre passe-bande 5 reliés ensemble dans cet ordre en série. Les filtres passe-bande 3 et 5 sont de types connus, de tels filtres sont notamment commercialisés par la Demanderesse sous les dénominations THOMSON-CSF 20856617 et 20856618, et par conséquent pour la bonne compréhension de l'invention leurs détails de réalisation n'ont pas besoin d'être plus longuement explicités. Sur la figure 1, l'entrée du dispositif de filtrage est figurée par la lettre A et sa sortie par la lettre E. La lettre B figure la liaison entre la sortie de l'amplificateur 2 et l'entrée des filtres 3, la lettre C figure la liaison entre la sortie du filtre 3 et l'entrée de l'amplificateur 4 et la lettre D figure la liaison entre la sortie de l'amplificateur 4 et l'entrée du filtre 5. Selon le dispositif représenté, le signal à filtrer est appliqué sur l'entrée A du dispositif et est transmis successivement au travers de l'amplificateur 2, du filtre 3, de l'amplificateur 4 et du filtre 5 pour ressortir filtré à la sortie E du dispositif.

Cette disposition permet d'obtenir à la sortie E du dispositif de filtrage 1 des signaux filtrés à très fort niveau d'énergie avec un rapport signal à bruit élevé et une très bonne réjection des raies parasites en dehors de la bande de filtrage. Pour parvenir à ces résultats, la première partie du dispositif de filtrage 1 constituée par l'amplificateur 2 et le filtre 3 a une caractéristique de filtrage qui correspond, à la condition d'amplitude près, au gabarit de filtrage prévu pour l'ensemble du dispositif 1 de filtrage. La deuxième partie du dispositif de filtrage 1 constituée par l'amplificateur 4 et le filtre 3 présente, à la sortie du filtre 5, une réponse amplitude fréquence qui a les caractéristiques de niveau et de bande passante correspondant au gabarit de filtrage souhaité pour l'ensemble du dispositif 1 avec cependant un coefficient d'atténuation hors bande qui a une valeur à peu près égale à la valeur du facteur de bruit de l'amplificateur 4. Lorsque ces conditions sont respectées, le filtrage à fort niveau de signal effectué par le filtre 5 compense la dégradation en bruit qui est apportée l'amplificateur 4 et le rapport signal à bruit obtenu à la sortie E du dispositif est le même que le rapport signal à bruit obtenu sur la liaison C à la sortie du filtre 5.

En effet, en désignant respectivement par $N_C$ et $B_T$ le niveau du signal et le niveau du bruit thermique obtenus à la sortie du filtre 3, et respectivement par $G_{CD}$ et $F_B$ le gain et le facteur de bruit de l'amplificateur 4, le rapport signal sur bruit obtenu sur la liaison D à la sortie de l'amplificateur 4 a pour expression

2

$$\frac{N_C}{B_T} \cdot \frac{G_{CD}}{F_B \cdot G_{CD}} = \frac{N_C}{B_T} \cdot \frac{1}{F_B}$$

Si $G_{DE}$ désigne la perte en niveau de signal occasionné par le filtre 5, le niveau de signal $N_E$ à la sortie du dispositif 1 a pour expression

$$N_E = N_C \cdot G_{CD} \cdot G_{DE}$$

et en désignant par F l'atténuation hors bande du filtre 5, le niveau de bruit $B_E$ obtenu à la sortie E du dispositif a pour expression

$$B_E = \frac{B_T \cdot F_B \cdot G_{CD} \cdot G_{DE}}{F}$$

et comme F est à peu près égal à $F_B$
le rapport signal à bruit obtenu à la sortie E du dispositif s'écrit

$$\frac{N_E}{B_E} \simeq \frac{N_C}{B_T}$$

ce qui vérifie bien le résultat annoncé précédemment.

Un fonctionnement du dispositif qui vient d'être décrit est illustré aux figures 2, 3 et 4 qui représentent respectivement les réponses amplitude-fréquence du filtre 3, de l'amplificateur 4 et du filtre 5 dans un cas pratique où le rapport signal à bruit obtenu à la sortie E du dispositif 1 est fixé à 139 dBm, le niveau $N_E$ est de 10 dBm et les pertes de niveau dans chacun des filtres 3 et 5 sont de 3 dBm. Pour obtenir le résultat illustré à la figure 2 le gain de l'amplificateur 2 a été réglé pour que le niveau du signal sur la liaison C à la sortie du filtre 3 soit de 0 dBm correspondant à une puissance de 1 mW avec un rapport signal à bruit de 139 dBm. Le gain de l'amplificateur 4 est porté à + 13 dBm pour compenser les 3 dBm de perte du filtre 5 et obtenir sur la sortie E le niveau demandé soit 10 dBm. Sur la figure 3 le niveau de bruit hors bande est remonté à la sortie de l'amplificateur 4 de 19 dBm par rapport au niveau de bruit thermique — 139 dBm, ce qui correspond pour l'amplificateur 4 à un facteur de bruit de 6 dBm. Pour obtenir les niveaux d'amplitude et le rapport signal à bruit souhaités à la sortie E du dispositif 1, le filtre 5 est défini de façon qu'au niveau de signal + 13 dBm appliqué à son entrée, la réjection des raies parasites et l'atténuation hors bande, soient juste supérieures à la valeur du facteur de bruit (6 dBm) de l'amplificateur 4. Le spectre du signal qui est obtenu dans ces conditions à la sortie E du dispositif 1 est représenté à la figure 4, son amplitude est de 10 dBm à l'intérieur de la bande de filtrage et le niveau de bruit hors bande est de − 129 dBm ce qui correspond bien au rapport signal à bruit de 139 dBm escompté.

## Revendications

1. Dispositif (1) pour l'amplification sélective de signaux radioélectriques comprenant un premier amplificateur (2) sur l'entrée duquel est appliqué le signal à amplifier, un deuxième amplificateur (4) couplé à la sortie du premier amplificateur (2) à travers un premier filtre passe-bande (3), ainsi qu'un deuxième filtre passe-bande (5) couplé à la sortie du deuxième amplificateur (4) fournissant le signal résultant filtré, caractérisé en ce que le premier amplificateur a une caractéristique d'amplification déterminée pour que le rapport des énergies du signal obtenu à la sortie du premier filtre (3) et du bruit thermique existant à la sortie du premier filtre (3) soit à peu près égal au rapport des énergies signal à bruit thermique recherché à la sortie du deuxième filtre (5), les premier et deuxième filtres (3, 5) ayant des bandes passantes identiques, le deuxième filtre (5) ayant une valeur d'atténuation hors bande à peu près égale à la valeur du facteur de bruit du deuxième amplificateur (4).

2. Dispositif selon la revendication 1, caractérisé en ce que l'énergie du signal à la sortie du premier filtre (3) est inférieure au niveau d'énergie du signal obtenu à la sortie du deuxième filtre (5).

3. Utilisation du dispositif selon les revendications 1 et 2 à la réalisation des chaînes du filtrage à fréquence intermédiaire des émetteurs de radiocommunication.

## Claims

1. A device (1) for the selective amplification of radioelectric signals, comprising a first amplifier (2), receiving at its input the signal to be amplified, a second amplifier (4) coupled to the output of the first amplifier (2) via a first band pass filter (3), and a second band pass filter (5) coupled to the output of the second amplifier (4) delivering the resulting filtered signal, characterized in that the first amplifier has an amplification characteristic determined in such a manner that the ratio between the energies of the signal obtained at the output of the first filter (3) and of the thermal noise existing at the output of the first filter (3) is approximately equal to the ratio which is desired to exist between the energies of the signal and the thermal noise at the output of the second filter (5), the first and second filters (3, 5) having identical pass bands and the second filter presenting an attenuation value off band which is approximately equal to the value of the noise factor of the second amplifier (4).

2. A device according to claim 1, characterized in that the energy of the output signal of the first filter (3) is lower than the energy level of the signal obtained at the output of the second filter (5).

3. The use of the device according to claims 1 and 2 in the implementation of intermediate frequency filter chains for radio transmitters.

## Patentansprüche

1. Vorrichtung (1) zur selektiven Verstärkung von Funksignalen, mit einem ersten Verstärker (2), an dessen Eingang das zu verstärkende Signal angelegt ist, einem zweiten Verstärker (4), der über ein erstes Bandpaßfilter (3) an den Ausgang des ersten Verstärkers (2) angekoppelt ist, und einem zweiten Bandpaßfilter (5), das an den zweiten Verstärker (4) gekoppelt ist und das gefilterte Endsignal liefert, dadurch gekennzeichnet, daß der erste Verstärker eine solche Verstärkungskennlinie besitzt, daß das Verhältnis zwischen den Energien des am Ausgang des ersten Filters (3) erhaltenen Signals und des am Ausgang des ersten Filters (3) vorhandenen Wärmerauschens ungefähr gleich dem gewünschten Signal/Rauschenergie-Verhältnis am Ausgang des zweiten Filters (5) ist, wobei das erste und zweite Bandpaßfilter (3, 5) identische Durchlaßbänder besitzen und das zweite Filter (5) außerhalb des Durchlaßbandes einen Dämpfungswert aufweist, der ungefähr gleich dem Wert des Rauschfaktors des zweiten Verstärkers (4) ist.

2. Vorrichtung nach Anspruch 1, dadurch gekennzeichnet, daß die Signalenergie am Ausgang des ersten Filters (3) kleiner als der am Ausgang des zweiten Filters (5) erhaltene Signalpegel ist.

3. Verwendung der Vorrichtung nach den Ansprüchen 1 und 2 bei der Herstellung von Zwischenfrequenzfilterketten für Radiosender.

EP 0 181 807 B1

Fig.1

Fig.2

Fig.3

Fig.4